(19) Europäisches Patentamt

European Patent Office

Office européen des brevets

(11) EP 0 566 805 B1

(12) **FASCICULE DE BREVET EUROPEEN**

(45) Date de publication et mention
de la délivrance du brevet:
**08.10.1997 Bulletin 1997/41**

(51) Int Cl.6: **F02P 17/00**

(21) Numéro de dépôt: **92403121.4**

(22) Date de dépôt: **20.11.1992**

(54) **Sonde de mesure pour circuit électrique d'allumage**

Messsonde für elektrischen Zündkreis

Measuring probe for ignition circuit

(84) Etats contractants désignés:
**DE ES GB IT**

(30) Priorité: **29.11.1991 FR 9114773**

(43) Date de publication de la demande:
**27.10.1993 Bulletin 1993/43**

(73) Titulaire: **REGIE NATIONALE DES USINES RENAULT S.A.**
**92109 Boulogne Billancourt (FR)**

(72) Inventeurs:
• **Guetta, Olivier**
**F-78400 Chatou (FR)**
• **Artur, Philippe**
**F-92800 Puteaux (FR)**

(56) Documents cités:
EP-A- 0 081 354         DE-A- 3 641 144
DE-A- 4 015 191         US-A- 3 886 441
US-A- 4 204 152

## Description

La présente invention a pour objet un dispositif de mesure des signaux électriques d'un circuit secondaire d'allumage de moteur à combustion interne équipant un véhicule automobile.

La question de la mesure des signaux électriques caractérisant le circuit secondaire est bien connue de l'industrie automobile car elle permet la surveillance des conditions de fonctionnement de l'allumage et en particulier de l'état d'usure de la bougie.

La publication US-A-4.601.193 (R. BLAUHAUT & AL.) décrit par exemple une sonde de mesure capacitive connectée en série avec le secondaire de la bobine d'allumage, entre la masse et ladite bobine. Cette sonde n'autorise pas toutefois une double mesure courant-tension et ne s'insère pas facilement en un autre point du circuit secondaire d'allumage.

Le document US-A-3 886 441 divulgue une sonde de mesure de la haute tension pourvue d'une borne d'entrée, d'une borne de sortie et d'une borne de masse et comprenant un pont diviseur résistif formé des résistances. Cette sonde de mesure comporte en outre un condensateur de compensation de fréquence destiné à compenser l'impédance entre la sonde et le circuit d'allumage.

Cette sonde présente les inconvénients d'une part, de ne pouvoir être disposée qu'en sortie de bobine du fait d'un encombrement important et d'autre part, de nécessiter un condensateur ce qui complique la réalisation de la pièce et renchérit son coût.

D'autres dispositifs de mesure du courant circulant vers la bougie sont présentés dans les publications FR-A-2.603.951 (S.A.G.E.M.) et GB-A-2.173.601 (FORD MOTOR Co Ltd). Ces dispositifs utilisent le rayonnement émis par une diode électroluminescente insérée dans le circuit secondaire, lequel rayonnement est fonction du courant traversant la diode. Ces dispositifs sont délicats à mettre en oeuvre.

Une mesure du courant de bougie et de la haute tension présente aux bornes de celle-ci est effectuée au moyen du système décrit par la publication FR-A-2.519.091 (DAIMLER-BENZ AG). Cette mesure est réalisée au moyen de deux sondes distinctes, l'une placée en amont du rupteur et l'autre aux bornes de la bougie, la sonde de mesure de la haute tension étant uniquement résistive et formée d'un pont diviseur. Ces sondes sont des appareils de test.

La présente invention vise à pallier les inconvénients précités en proposant un dispositif de mesure peu coûteux utilisable quel que soit le type d'allumage équipant le véhicule et qui peut être placé soit en sortie de bobine, soit sur le distributeur, soit encore directement sur la bougie, sans modification aucune de ces éléments. Ce dispositif est de façon préférentielle monté à demeure dans le circuit pour fournir au conducteur des informations sur l'état du sytème d'allumage.

Selon l'invention, le dispositif ou sonde de mesure équipant un circuit d'allumage haute tension d'un moteur à combustion interne, en particulier pour véhicules automobiles, comporte des moyens de mesure du courant de bougie et de la haute tension aux bornes de celle-ci. Le dispositif selon l'invention est caractérisé en ce que les moyens de mesure de la haute tension sont uniquement résistifs et formés d'un pont diviseur et les moyens de mesure du courant sont purement résistifs.

Selon d'autres aspects encore, la sonde peut-être connectée en série dans le circuit secondaire d'allumage entre le câble haute tension et la bougie, elle peut se loger dans le puits de bougie de culasse et est constituée d'un circuit électrique uniquement résistif.

Pour cela, cette sonde présente des caractéristiques électriques, mécaniques et dimensionnelles adaptées à l'environnement hostile que présente le moteur d'un véhicule automobile, à savoir :

- une résistance élevée afin de ne pas perturber le fonctionnement de la bougie et éviter les courants de fuite vers les nombreuses parties métalliques ;

- une isolation élevée de l'ordre de 40 KV de façon à être utilisable sur tout type de véhicule ;

- une résistance à la haute température engendrée par la proximité des parties actives du moteur à combustion interne ;

- une résistance aux vibrations mécaniques nombreuses sur de tels moteurs ;

- des dimensions réduites permettant le logement de ladite sonde dans le puits de bougie de culasse.

Pour atteindre ces objectifs, la sonde proposée présente un circuit électrique uniquement résistif composé de résistances montées en ponts diviseurs et atténuateur sur lesquels sont prélevées les images du courant et de la tension. Chaque pont diviseur comporte un nombre de résistances connectées en série tel que sa tension de claquage soit située au-delà de 40 KV.

Selon un premier mode de réalisation de l'invention, la sonde insérable entre le câble haute tension et la bougie, est bâtie autour d'une tige de laiton entourée d'un tube de nylon résistant à la température. La tige possède un clips sur lequel se connecte le câble haute tension et traverse un cylindre de résine epoxy contenant les résistances du circuit électrique. La sonde possède à sa base un évidement de réception d'une bougie et son diamètre autorise son insertion dans le puits de bougie de culasse.

Selon un deuxième mode de réalisation de l'invention, la sonde est solidaire du câble haute tension et prend position dans la tétine de caoutchouc située côté bougie.

On comprendra mieux les buts, aspects et avantages de la présente invention, d'après la description donnée ci-après d'un mode de réalisation de l'invention, donné à titre d'exemple non limitatif, en se référant aux dessins annexés, dans lesquels :

- la figure 1 représente le schéma électrique d'une sonde de mesure de tension et de courant ;

- la figure 2 représente une vue en coupe d'une sonde de mesure de tension et de courant ;

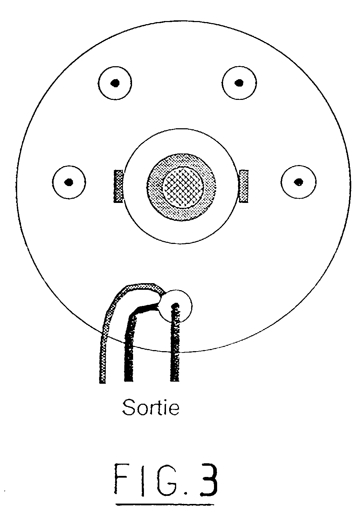

- la figure 3 représente une vue de dessus de la sonde de mesure selon l'invention.

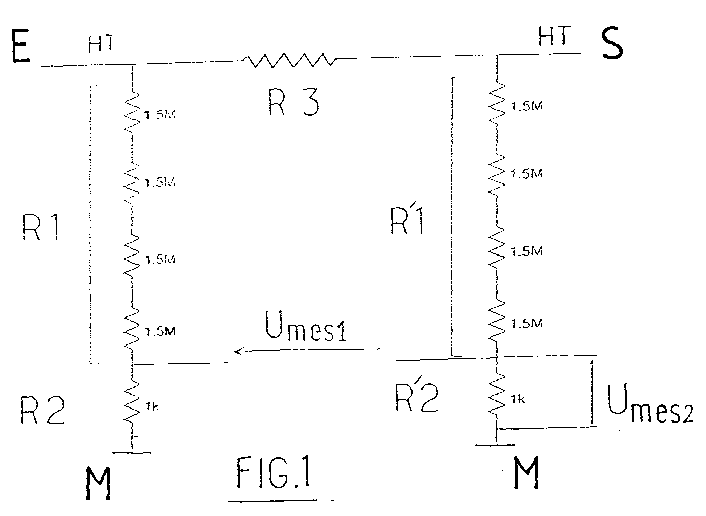

La figure 1 représente le schéma électrique d'une sonde selon l'invention, permettant la mesure du courant et de la tension de bougie Ce circuit se compose d'un atténuateur différentiel constitué de deux ponts diviseurs ($R_1$, $R_2$ et $R'_1$, $R'_2$) reliés par une résistance $R_3$ ($R_3 = 4,7 \text{ K } \Omega$) placée en série dans le circuit d'allumage.

Ces ponts diviseurs se composent de deux résistances de valeurs élevées (par exemple ($R_1 = R'_1 = 6M \Omega$ ; $R_2 = R'_2 = 1K \Omega$). La première résistance ($R_1$, $R'_1$) est choisie de valeur élevée afin de ne pas perturber le circuit d'allumage. La précision de ($R_1$, $R'_1$) et ($R_2$, $R'_2$) sera maximale.

Les résistances disponibles aujourd'hui étant aux maximum isolées à 10 KV, les résistances $R_1$, $R'_1$ devront être constituées d'au moins trois résistances isolées à 10 KV et branchées en série. La valeur totale de $R_1$ et de $R'_1$ reste égale à 6 M $\Omega$ et l'isolation du système devient telle que la sonde peut-être utilisée dans des circuits de tension de l'ordre de 40 KV.

Sur ce schéma, Is représente le courant d'allumage ou de bougie et E, S, M, Ue, Us désignent respectivement les bornes d'entrée, de sortie et de masse de la sonde et les tensions d'entrée et de sortie de la sonde.

En appliquant la loi d'Ohm, on peut écrire :

$$Is = \frac{1}{R_3} (Ue - Us) = \frac{1}{4,7 \text{ K}} (Ue - Us)$$

et

soient Umes1 et Umes2 les tensions mesurées sur le pont atténuateur.

$$Umes1 = \frac{R_2}{R_1 + R_2} Ue - \frac{R'_2}{R'_1 + R'_2} Us \text{ avec } R_1 = R'_1 \text{ et } R_2 = R'_2$$

soit encore

$$Umes1 = \frac{R_2}{R_1 + R_2} (Ue - Us) = \frac{1K}{6000K} (Ue - Us)$$

d'où

$$Is = \frac{6000}{4,7K} Umes1$$

La tension et le courant cherchés sont donc donnés par :

$$Us = Ubougie = 6000 \ Umes2$$

et

$$Is\ (mA) = 1280\ Umes1$$

Pour les mêmes raisons d'isolation que précédemment les résistances $R'_1$ et $R_1$ doivent être réalisées au moyen d'au moins trois résistances isolées chacune à 10 KV et branchées en série.

Pour obtenir la meilleure image possible du courant Is, les résistances des deux ponts diviseurs doivent être de valeurs les plus proches possibles ($R_1 = R'_1$ et $R_2 = R'_2$).

D'autre part un compromis doit être trouvé pour le choix de $R_3$. Une valeur élevée augmente la précision de la mesure de courant en fin d'étincelle mais "gaspille" plus d'énergie au début de l'étincelle laissant moins d'énergie disponible pour l'allumage. Une valeur de $R_3$ faible provoque les effets inverses. Un bon compromis est donné par une valeur de $R_3$ proche de la somme des résistances des câbles haute tension.

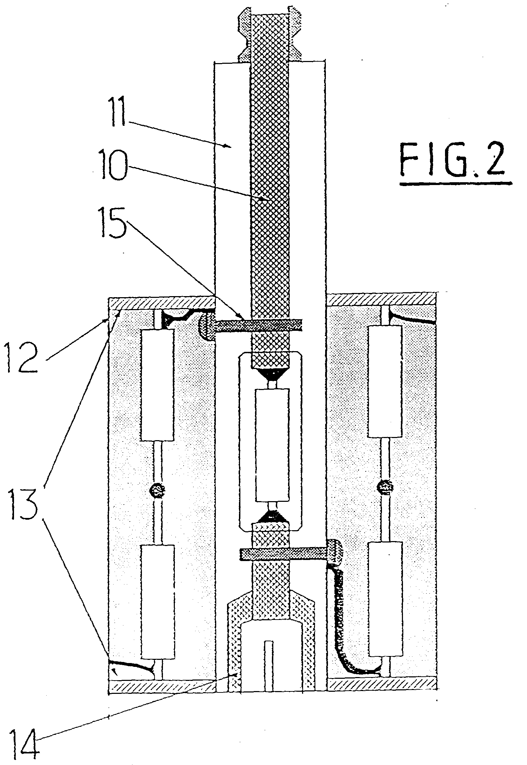

La figure 2 représente une vue en coupe d'une réalisation pratique de la sonde de mesure de tension et de courant selon l'invention.

La sonde se compose d'une tige de laiton filetée 10 conductrice placée dans un tube de nylon isolant 11. Le tube et la tige sont tous deux résistants aux fortes températures. La tige de laiton possède à son extrémité supérieure un clips sur lequel peut venir se connecter le câble haute tension du circuit d'allumage, et à sa base un évidemment 14 en forme de clips décolleté pouvant recevoir l'extrémité d'une bougie d'allumage ou d'une bobine.

Les résistances connectées selon le schéma de la figure 1 sont disposées parallèlement à la tige de laiton, à égale distance de celle-ci selon le schéma de la figure 4. Elles sont maintenues mécaniquement à leurs extrémités au moyen de deux disques 13 de PVC traversés par ladite tige et le tube isolant. Entre et sur ces disques est coulée une résine exposy 12 isolante à 15 KV/mm et résistant à des températures de l'ordre de 120°C.

La tige de laiton 10 est interrompue afin de placer entre les deux barreaux formés par la coupure de celle-ci une résistance de 4,7 K $\Omega$. Cette résistance se trouve donc elle aussi à l'intérieur du tube isolant. Les deux barreaux de la tige de laiton interrompue formant les bornes E et S de la sonde telle que décrite figure 1b, doivent être connectés chacun aux résistances d'un pont diviseur, cela est réalisé au moyen de deux vis de laiton 15 traversant le tube de nylon isolant et lesdits barreaux.

Avant de couler la résine, on aura eu soin de relier un câble blindé (non représenté) aux extrémités des résistances $R_2$ et $R'_2$ afin de pouvoir prélever la mesure cherchée.

Selon un second mode de réalisation non représenté les résistances de ces sondes sont insérées dans la tétine de caoutchouc d'un câble standard haute tension de circuit d'allumage.

Bien entendu, l'invention n'est nullement limitée au mode de réalisation décrit et illustré qui n'a été donné qu'à titre d'exemple.

Au contraire, l'invention comprend tous les équivalents techniques des moyens décrits ainsi que leurs combinaisons si celles-ci sont conformes aux revendications annexées.

## Revendications

1. Sonde de mesure destinée à équiper le circuit électrique d'allumage haute tension d'une bougie de moteur à combustion interne, en particulier pour véhicules automobiles, du type comportant une borne d'entrée (E), une borne de sortie (S), une borne de masse (M) et des moyens ($R_1$, $R_2$, $R_3$, $R'_1$, $R'_2$) permettant la mesure de la haute tension aux bornes de la bougie et du courant de bougie, lesdits moyens de mesure de la haute tension étant formés par un premier pont diviseur connecté entre la borne de sortie et la borne de masse, l'image de la haute tension à mesurer étant prélevée aux bornes de la résistance ($R'_2$) du pont diviseur connectée à la masse, caractérisée en ce que les moyens de mesure du courant de bougie sont constitués par un circuit électrique uniquement résistif.

2. Sonde de mesure selon la revendication 1, caractérisée en ce qu'un deuxième pont diviseur est branché entre la borne d'entrée et la borne de masse et qu'entre les bornes d'entrée et de sortie est connectée une résistance ($R_3$) parcourue par le courant de bougie.

3. Sonde de mesure selon la revendication 2, caractérisée en ce que les deux ponts diviseurs sont rigoureusement identiques et que la mesure du courant de bougie est donnée en effectuant la différence des tensions prélevées aux bornes des deux résistances ($R_2$, $R'_2$) connectées à la masse.

4. Sonde de mesure selon l'une quelconque des revendications 1 à 3, caractérisée en ce qu'elle est constituée d'une tige de laiton filetée (10) conductrice, résistant à la température sur laquelle le câble standard haute tension du circuit électrique d'allumage est destiné à être monté, ladite tige étant entourée sur toute sa longueur d'un tube de nylon (11) isolant et résistant à la température, lui-même en partie entouré d'un cylindre de résine epoxy (12) isolant et résistant à la température dans lequel sont noyées les résistances du circuit électrique.

5. Sonde de mesure selon la revendication 4, caractérisée en ce que la tige de laiton (10) possède à sa base un évidement en forme de clip décolleté (14) permettant la connexion de la sonde directement avec la bougie ou la bobine.

6. Sonde de mesure selon la revendication 4, caractérisée en ce que les résistances sont disposées verticalement entre deux disques de maintien en PVC (13) traversés par le tube de nylon et que la résine epoxy est coulée entre et sur ces deux disques, noyant les résistances.

7. Sonde de mesure selon l'une quelconque des revendications 4 à 6, caractérisée en ce que la tige de laiton est interrompue et que les deux barreaux ainsi formés sont reliés par l'intermédiaire d'une résistance.

8. Sonde de mesure selon l'une quelconque des revendications 4 à 7, caractérisée en ce que les circuits de résistances sont reliés à la tige de laiton par l'intermédiaire de vis (15) de laiton traversant ladite tige et le tube de nylon.

**Patentansprüche**

1. Messsonde zum Bestücken des elektrischen Hochspannungszündkreises einer Zündkerze eines Verbrennungsmotors, insbesondere für Kraftfahrzeuge, von dem Typ der eine Eingangsklemme (E), eine Ausgangsklemme (S), eine Erdungsklemme (M) und Mittel ($R_1$, $R_2$, $R_3$, $R'_1$, $R'_2$) aufweist, die die Messung der Hochspannung an den Klemmen der Zündkerze und die Messung des Stromes der Zündkerze ermöglichen, wobei die Messmittel der Hochspannung aus einer ersten Teilerbrücke gebildet sind, die zwischen der Ausgangsklemme und der Erdungsklemme geschaltet ist und der Wert der zu messenden Hochspannung an den Klemmen des mit der Erde verbundenen Widerstandes ($R'_2$) der Teilerbrücke abgenommen wird, dadurch gekennzeichnet, dass die Mittel zur Messung des Stromes der Zündkerze aus einem ausschliesslich resistiven elektrischen Schaltkreis bestehen.

2. Messsonde nach Anspruch 1, dadurch gekennzeichnet, dass eine zweite Teilerbrücke zwischen der Eingangsklemme und der Erdungsklemme geschaltet ist und dass zwischen der Eingangsklemme und der Ausgangsklemme ein Widerstand ($R_3$) geschaltet ist, der vom Strom der Zündkerze durchflossen wird.

3. Messsonde nach Anspruch 2, dadurch gekennzeichnet, dass die zwei Teilerbrücken genau identisch sind und dass die Messung des Stromes der Zündkerze durch das Messen der Spannungsdifferenz an den Klemmen der beiden Widerstände ($R'_2$, $R'_2$) erfolgt, die mit der Erde verbunden sind.

4. Messsonde nach einem der Ansprüche 1 bis 3, dadurch gekennzeichnet, dass sie aus einer mit einem Gewinde versehenen, leitenden hitzebeständigen Messingstange (10) besteht, an die das Standard-Hochspannungskabel des elektrischen Zündkreises anschliessbar ist, wobei die Stange über ihre gesamte Länge von einem Nylon-Rohr (11) umhüllt ist, das isolierend und hitzebeständig ist, das selbst zum Teil von einem Zylinder aus Epoxidharz (12) umhüllt ist, der isolierend und hitzebeständig ist, in dem die Widerstände des elektrischen Schaltkreises eingebettet sind.

5. Messsonde nach Anspruch 4, dadurch gekennzeichnet, dass die Messingstange (10) an ihrer Basis eine Aussparung in Form einer ausgeschnittenen Klemme (14) enthält, die die direkte Verbindung der Sonde mit der Zündkerze oder mit der Spule ermöglicht.

6. Messsonde nach Anspruch 4, dadurch gekennzeichnet, dass die Widerstände vertikal zwischen zwei Haltescheiben aus PVC (13) angeordnet sind, die von dem Nylon-Rohr durchsetzt sind, und dass das Epoxidharz zwischen und auf den Scheiben gegossen ist und dabei die Widerstände einbettet.

7. Messsonde nach einem der Ansprüche 4 bis 6, dadurch gekennzeichnet, dass die Messingstange unterbrochen ist, und dass die so geformten Stäbe mittels eines Widerstandes verbunden sind.

8. Messsonde nach einem der Ansprüche 4 bis 7, dadurch gekennzeichnet, dass die Schaltkreise der Widerstände mit der Messingstange mittels Schrauben (15) aus Messing verbunden sind, die die Stange und das Nylon-Rohr durchsetzen.

**Claims**

1. Measuring probe intended to be fitted to the high voltage electric ignition circuit of a spark plug of an internal combustion engine, in particular for automotive vehicles, of the type comprising an input terminal (E), an output terminal (S), an earth terminal (M) and means ($R_1$, $R_2$, $R_3$, $R'_1$, $R'_2$) allowing measurement of the high voltage at the spark plug terminals and of the spark plug current, said means for measuring the high voltage being formed by a first dividing bridge connected between the output terminal and the earth terminal, the pattern of the high voltage to be measured being taken from the terminals of the resistor ($R'_2$) of the dividing bridge connected to the earth, characterised in that the means for measuring the spark plug current are constituted by an exclusively resistive electric circuit.

2. Measuring probe according to claim 1, characterised in that a second dividing bridge is connected between the input terminal and the earth terminal and that between the input and output terminals there is connected a resistor ($R_3$) passed through by the spark plug current.

3. Measuring probe according to claim 2, characterised in that the two dividing bridges are strictly identical and that the measurement of the spark plug current is given by taking the difference between the voltages taken at the terminals of the two resistors ($R_2$, $R'_2$) connected to the earth.

4. Measuring probe according to any one of claims 1 to 3, characterised in that it is constituted by a heat resistant threaded conductive brass rod (10), on which the standard high voltage cable of the electric ignition circuit is intended to be mounted, said rod being surrounded over its entire length by an insulating and heat resistant nylon tube (11), itself being partially surrounded by an insulating and heat resistant cylinder of epoxy resin (12), in which the resistors of the electric circuit are embedded.

5. Measuring probe according to claim 4, characterised in that the brass rod (10) is provided at its base with a cut-out in the form of a cut-out clip (14) allowing the connection of the probe directly to the spark plug or the coil.

6. Measuring probe according to claim 4, characterised in that the resistors are arranged vertically between two PVC retaining discs (13) passed through by the nylon tube, and that the epoxy resin is applied between and on the two discs, embedding the resistors.

7. Measuring probe according to any one of claims 4 to 6, characterised in that the brass rod is discontinuous and that the two bars thus formed are connected by means of a resistor.

8. Measuring probe according to any one of claims 4 to 7, characterised in that the circuits of the resistors are connected to the brass rod by means of a brass screw (15) passing through said rod and the nylon tube.

FIG.1

11

10

15

12

13

14

FIG.2

Sortie

FIG. 3